Europäisches Patentamt

European Patent Office

Office européen des brevets

(19)

(11) Veröffentlichungsnummer: **0 268 081 B1**

## EUROPÄISCHE PATENTSCHRIFT

(12)

(45) Veröffentlichungstag der Patentschrift: **15.04.92**

(51) Int. Cl.⁵: **H01L 23/42**

(21) Anmeldenummer: **87115118.9**

(22) Anmeldetag: **16.10.87**

(54) **Vorrichtung zur Kühlung von Halbleiterbauelementen.**

(30) Priorität: **29.10.86 CH 4279/86**

(43) Veröffentlichungstag der Anmeldung:
**25.05.88 Patentblatt 88/21**

(45) Bekanntmachung des Hinweises auf die
Patenterteilung:
**15.04.92 Patentblatt 92/16**

(84) Benannte Vertragsstaaten:
**AT BE CH DE ES FR IT LI SE**

(56) Entgegenhaltungen:
| | |
|---|---|
| **CH-A- 342 661** | **DE-A- 2 825 582** |
| **DE-A- 3 302 840** | **GB-A- 2 039 416** |
| **US-A- 2 886 746** | **US-A- 3 852 806** |

**PATENT ABSTRACTS OF JAPAN, Band 5, Nr.
44 (E-50)[716], 24. März 1981; & JP-A-55 165
658 (FUJITSU K.K.) 24-12-1980**

Idem

**IBM TECHNICAL DISCLOSURE BULLETIN,
Band 13, Nr. 5, Oktober 1970, Seite 1048, New
York, US; P.W. ING: "Self-cooling heat
exchanger-condenser"**

(73) Patentinhaber: **BBC Brown Boveri AG
Haselstrasse
CH-5401 Baden(CH)**

(72) Erfinder: **Vogel, Xaver
Pfaffenziel 10
CH-5300 Turgi(CH)**

## Beschreibung

Bei der Erfindung wird ausgegangen von einer Kühlvorrichtung für elektrische Bauelemente nach dem Oberbegriff des Patentanspruchs.

STAND DER TECHNIK

Mit dem Oberbegriff nimmt die Erfindung auf einen Stand der Technik Bezug, wie er aus der DE-A-2 825 582 bekannt ist. Dort ist eine Kühlvorrichtung für elektrische Leistungshalbleiterbauelemente angegeben, bei denen zwischen den Halbleiterbauelementen und den in eine Kühlflüssigkeit hineinragenden Dochten stets eine Isolationsplatte z. B. aus Berylliumoxid vorgesehen ist, welche teilweise direkt mit der Kühlflüssigkeit in Verbindung steht.

Aus der CH-A-342 661 ist ein Kühler für die Kühlung eines Halbleiterelementes hoher Strombelastung bekannt, bei dem ein oder mehrere Halbleiterelemente unmittelbar an einer mit Höckern oder Rippen versehenen Metallplatte anliegen, wobei die Metallplatte die Bodenplatte eines gasdichten Gefässes bildet, dessen Metallwandung Kühlrippen aufweist. Im Inneren des Gefässes ist als verdampfbare Kühlflüssigkeit Wasser unter einem solchen Unterdruck eingeschlossen, dass es bei weniger als 70 °C siedet.

Für die forcierte Kühlung von Halbleiterbauelementen sind verschiedene Verfahren bekannt. Speziell bei der Anwendung in Traktionsfahrzeugen werden zunehmend wartungsfreie leistungselektronische Geräte verlangt. Dies führt dazu, dass für die Abfuhr der in den Geräten erzeugten Verlustleistung ungefilterte Luft vorgesehen werden muss. Da eine direkte Kühlung der Bauelemente mit ungefilterter Luft jedoch wegen der Verschmutzungsgefahr ausscheidet, kommt in diesem Zusammenhang nur die Verwendung eines primären, geschlossenen Kühlkreislaufs in Betracht. Eine solche geschlossene, effektive Kühlung ist seit längerem unter der Bezeichnung Siedekühlung bekannt.

Bei der Siedekühlung bringt das zu kühlende Bauelement eine geeignete Kühlflüssigkeit, zum Beispiel das Kältemittel R113, zum Sieden. Der dabei erzeugte Dampf kondensiert an einer entfernt angeordneten Kühlfläche unter Wärmeabgabe wieder und das Kondensat wird in das Kühlflüssigkeits-Reservoir zurückgeführt.

Mit der Siedekühlung lassen sich kompakte, platzsparende und wartungsarme leistungselektronische Geräte verwirklichen. Eine umfassende Uebersicht über diese Kühltechnik gibt beispielsweise der Artikel von J. Nestler, P. Heinemeyer und M. Steinweg in Bull. SEV/VSE 72 (1981), S. 239-244.

Wie in dem genannten Artikel näher dargelegt wird, sind im wesentlichen zwei Aufbausysteme der Siedekühlung bekannt und zu unterscheiden, die hier als Kesselkühlung und als Dosenkühlung bezeichnet werden sollen.

Bei der Kesselkühlung (direkte Siedekühlung) befinden sich die zu kühlenden Bauelemente innerhalb eines vakuumdicht geschlossenen Behälters (Kessel), direkt in die Kühlflüssigkeit eingetaucht. Dabei werden, wenn es sich z.B. um einen vollständigen Stromrichter handelt, nicht nur die Thyristoren und Dioden durch die Kühlflüssigkeit gekühlt, sondern auch die Beschaltungen und andere wärmeabgebende Bauelemente des Stromrichters.

Ein Vorteil der Kesselkühlung ist neben der gleichmässigen Kühlmitteltemperatur für alle Bauelemente und dem Schutz vor Verschmutzung vor allem der enge thermische Kontakt der Bauelemente zur Kühlflüssigkeit, ihre Isolation vom Kühler und der kompakte Aufbau.

Ein Nachteil der Kesselkühlung ist, dass die Bauelemente nicht zugänglich sind, dass für die elektrischen Zuleitungen spezielle Durchführungen benötigt werden, und dass das Aufbausystem für jede Art von Stromrichter oder sonstiger Schaltung speziell ausgelegt werden muss, d.h. keine modulare Flexibilität zulässt.

Bei der Dosenkühlung (indirekte Siedekühlung) wird die Verlustwärme des einzelnen Bauelements (z.B. Scheiben-Thyristors) durch eine ihm zugeordnete Siedekühldose abgeführt, die an einen Kühlflüssigkeitskreislauf angeschlossen ist.

Die Dosenkühlung zeichnet sich dadurch aus, dass die zu kühlenden Bauelemente leicht auswechselbar sind und elektrische Durchführungen wie bei der Kesselkühlung entfallen. Darüberhinaus ist dieses Aufbausystem modulfähig, d.h. Bauelemente und Kühldosen können in verschiedener Weise miteinander kombiniert und zu grösseren Einheiten zusammengestellt werden.

Nachteilig ist hierbei, dass die Kühldosen nicht von den Bauelementen isoliert sind und das komplette System aus Kühldosen, Dampfleitungen und Vorratsgefäss eine vergleichsweise komplizierte und wenig kompakte Anordnung bildet.

Die Erfindung, wie sie im Patentanspruch definiert ist, löst die Aufgabe, eine Kühlvorrichtung für elektrische Bauelemente der eingangs genannten Art derart weiterzuentwickeln, dass ein kompakter Aufbau und eine effiziente Kühlung mit Einfachheit und Modulfähigkeit kombiniert sind.

Insgesamt zeichnet sich die erfindungsgemässe Kühlvorrichtung durch folgende Vorteile aus:
- Durch die Verwendung kleiner Einheiten (1 ... 3 Halbleiterbauelemente pro Kühlkörper) ergibt sich eine hohe Modularität mit günstigen Bedingungen für Fabrikation, Montage, Prüfung und Service.
- Der Einbau in ein Traktionsfahrzeug kann freizügig gestaltet werden.
- Der Kühlkörper befindet sich auf Erdpotential.

- Der thermische Widerstand der Gesamtanordnung ist gering.
- Die Kondensationswege sind kurz.
- Der Unterhalt für die Kühlung ist minimal.

KURZE BESCHREIBUNG DER ZEICHNUNGEN

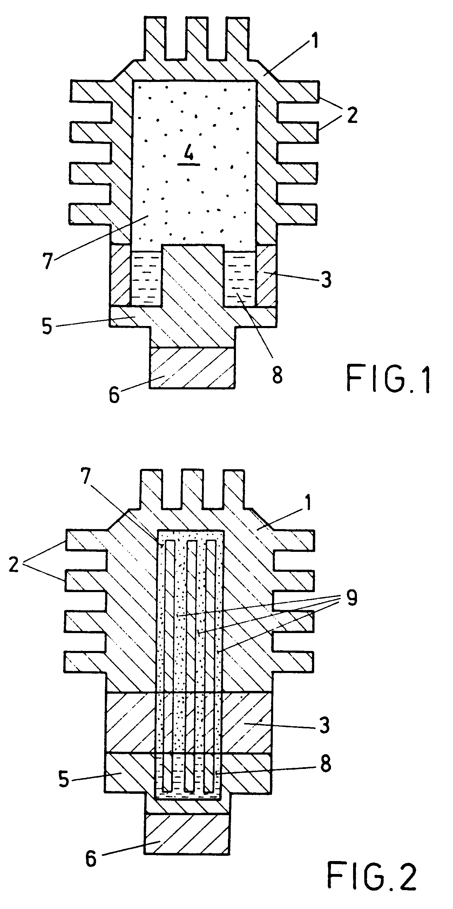

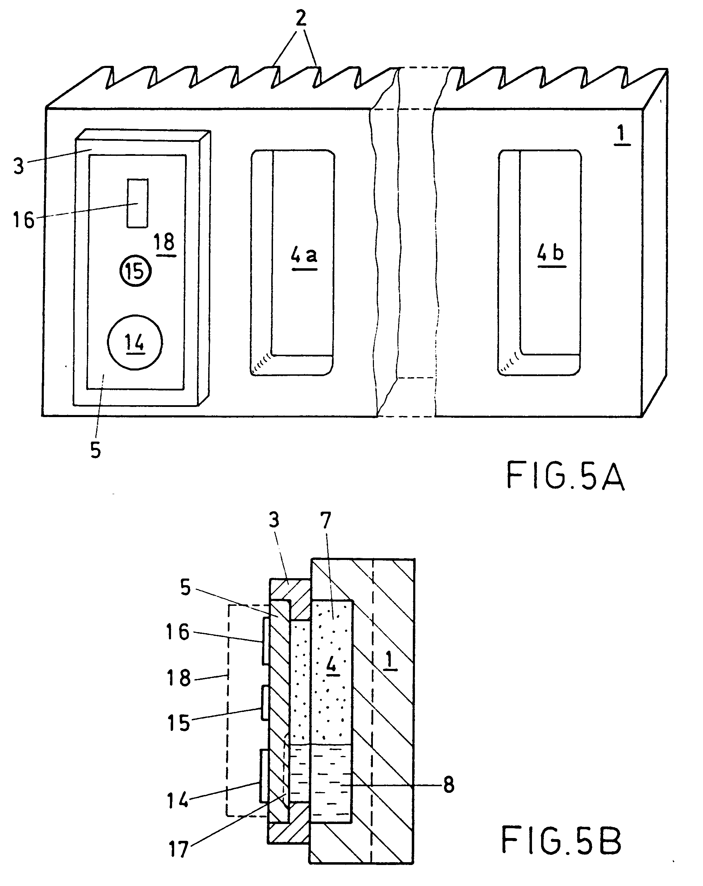

Die Erfindung wird nachstehend anhand von Ausführungsbeispielen erläutert. Es zeigen:
Fig. 1
eine schematisierte Darstellung einer Kühlvorrichtung gemäss einem bevorzugten Ausführungsbeispiel der Erfindung,
Fig. 2
eine der Fig. 1 entsprechende Darstellung, bei welcher als Hohlraum im Kühlkörper mehrere miteinander kommunizierende Kühlkanäle vorgesehen sind,
Fig. 3
ein Ausführungsbeispiel der Erfindung für eine forcierte Luftkühlung,
Fig. 4
ein weiteres Ausführungsbeispiel für die Unterflurmontage bei Traktionsfahrzeugen mit Fahrtwindkühlung und
Fig. 5A und 5B
Ausführungsbeispiele für die Kühlung von Leistungshalbleiter-Modulen in perspektivischer Ansicht (Fig. 5A) und im Querschnitt (Fig. 5B).

WEGE ZUR AUSFÜHRUNG DER ERFINDUNG

Eine in Fig. 1 dargestellte Kühlvorrichtung zur Kühlung eines Verlustwärme abgebenden Halbleiterbauelements 6 umfasst als wesentliche Bestandteile einen Kühlkörper 1 mit einem innenliegenden Hohlraum 4, einen Wärmeableiter 5 und ein isolierendes Zwischenstück 3.

Der Kühlkörper 1 mit seinem Hohlraum 4 ist für sich genommen auf einer Seite, in Fig. 1 nach unten hin, offen ausgeführt. Geschlossen wird diese Oeffnung durch de n Wärmeableiter 5, der über das isolierende Zwischenstück 3 mit dem Kühlkörper 1 fest verbunden ist und den Hohlraum 4 nach aussen hin gasdicht abschliesst.

Auf der dem Hohlraum 4 abgewandten Seite des Wärmeableiters 5 ist mit einem möglichst geringen thermischen Uebergangswiderstand das Halbleiterbauelement 6 befestigt. Die dem Hohlraum 4 zugewandte Seite des Wärmeableiters 5 steht in Kontakt mit einer im Arbeitstemperaturbereich siedenden Kühlflüssigkeit 8, die den Hohlraum 4 nur teilweise ausfüllt und über sich einen entsprechenden Gasraum 7 freilässt, in dem der beim Kühlvorgang erzeugte Dampf zirkuliert.

Im Bereich des Gasraums 7 sind auf der Aussenseite des Kühlkörpers 1 eine Mehrzahl von Kühlrippen 2 angeordnet, um den Uebergang der Wärme, die beim Kondensieren des Dampfes an den Innenwänden entsteht, an die Umgebung zu erleichtern. Alternativ kann der Kühlkörper 1 auch als Wärmetauscher ausgebildet sein.

Aus demselben Grund ist auch der Wärmeableiter 5 in der Vorrichtung nach Fig. 1 so ausgebildet, dass er in den Hohlraum 4 hineinragt. Zusätzlich können an dem in die Kühlflüssigkeit 8 hineinragenden Teil des Wärmeableiters 5 auch noch Kühlrippen vorgesehen werden, um die am Wärmeübergang beteiligte Fläche zu vergrössern.

Der Wärmeableiter 5 und der Kühlkörper 1 bestehen vorzugsweise aus einem gut wärmeleitendem Metall, insbesondere aus Kupfer oder Aluminium. Das isolierende Zwischenstück 3 kann beispielsweise aus einem Kunststoff oder einer Keramik hergestellt werden.

Wärmeableiter 5, isolierendes Zwischenstück 3 und Kühlkörper 1 können entweder miteinander verklebt, verlötet (bei einem isolierenden Zwischenstück 3 aus Keramik) oder mit den entsprechenden Dichtungen verschraubt werden.

Eine zu Fig. 1 alternative Anordnung verzichtet ganz auf das isolierende Zwischenstück 3, indem der Kühlkörper 1 selbst aus einem isolierenden Material besteht.

Wichtig für die Aufrechterhaltung der Isolierung zwischen Kühlkörper 1 und Halbleiterbauelement 6, auch bei den heutzutage üblichen Sperrspannungen von mehreren kV, ist jedenfalls ein hinreichend grosser Kriechweg, insbesondere auf der Aussenseite des isolierenden Zwischenstücks 3, der durch eine entsprechende Formgebung, wie sie von herkömmlichen Isolatoren bekannt ist, erreicht werden kann.

Als Kühlflüssigkeit 8 wird bevorzugt ein relativ niedrig siedendes Kältemittel verwendet, wie es unter der Bezeichnung R113 (Handelsnamen Frigen 113, Kaltron 113 oder Freon TF) bekannt ist.

Wenn das Flüssigkeitsvolumen aus Gewichts-, Preis- oder Sicherheitsgründen möglichst klein gehalten werden soll, können, wie in Fig. 2 dargestellt, anstelle des ausgedehnten Hohlraumes 4 gemäß Fig. 1, mehrere miteinander kommunizierende Kühlkanäle 9 vorgesehen werden, die zwischen dem Wärmeableiter 5 und dem Kühlkörper 1 verlaufen und den Wärmetransport über den Kühlmitteldampf bewerkstelligen.

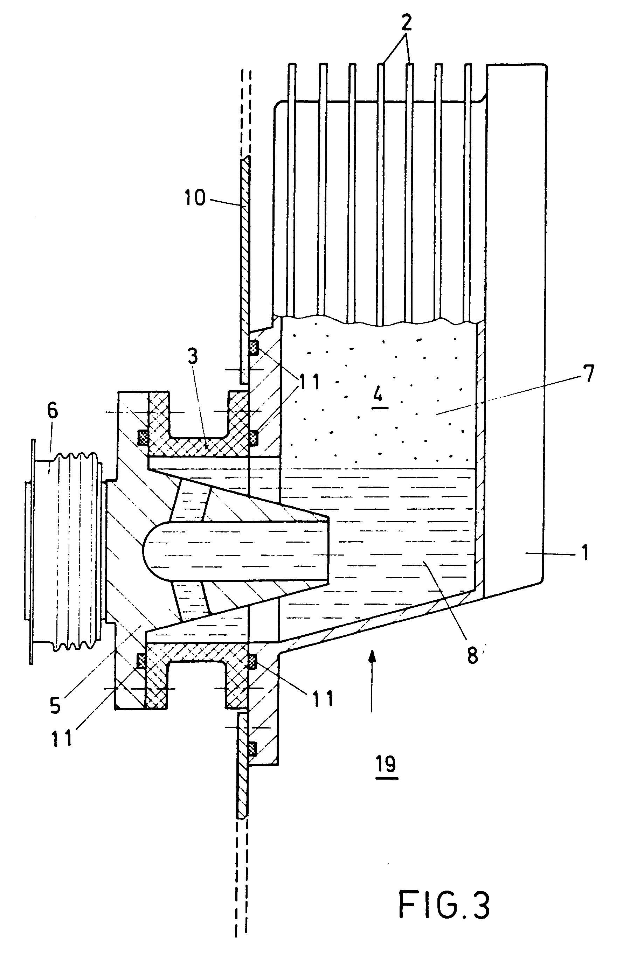

Eine praktisch erprobte Ausführungsform der erfindungsgemässen Vorrichtung, bei der die charakteristischen Elemente aus der schematischen Darstellung der Fig. 1 leicht wiederzuerkennen sind, ist in Fig. 3 wiedergegeben.

Die Figur zeigt den Ausschnitt aus einem Luftkanal 19, der die rechte Seite des Bildes einnimmt und nach links durch eine Kanalwand 10 begrenzt ist. Der Luftkanal 19 wird in Richtung des eingezeichneten Pfeiles von Luft, insbesondere ungefilterter Luft, durchströmt.

Innerhalb des Luftkanals 19 ist der Kühlkörper 1 mit den aussen angebrachten Kühlrippen 2 angeordnet. Der Kühlkörper 1 ist mit entsprechenden Dichtungen 11 an einer Oeffnung in der Kanalwand 10 befestigt, derart, dass die offene Seite seines Hohlraumes 4 durch die Kanalwandöffnung von aussen zugänglich ist.

An der offenen Seite des Kühlkörpers 1 ist mit Dichtungen 11 das flanschartige isolierende Zwischenstück 3 angeschraubt, an das isolierende Zwischenstück 3 seinerseits der Wärmeableiter 5, der mit einem durchbohrten, koni sch zulaufenden Teilstück in den Hohlraum 4 und damit in die Kühlflüssigkeit 8 hineinragt.

Auf der Aussenseite des Wärmeableiters 5 ist in diesem Beispiel ein Hochleistungs-Scheibenthyristor bekannter Bauart derart angebracht, dass er mit einer seiner elektrischen Kontaktflächen grossflächig am Wärmeableiter 5 anliegt.

Man erkennt an diesem Beispiel deutlich den kesselartigen Charakter der Kühlanordnung, mit dem Unterschied zur bekannten Kesselkühlung, dass anstelle des Bauelements stellvertretend der Wärmeableiter 5 in die Kühlflüssigkeit 8 eingetaucht ist.

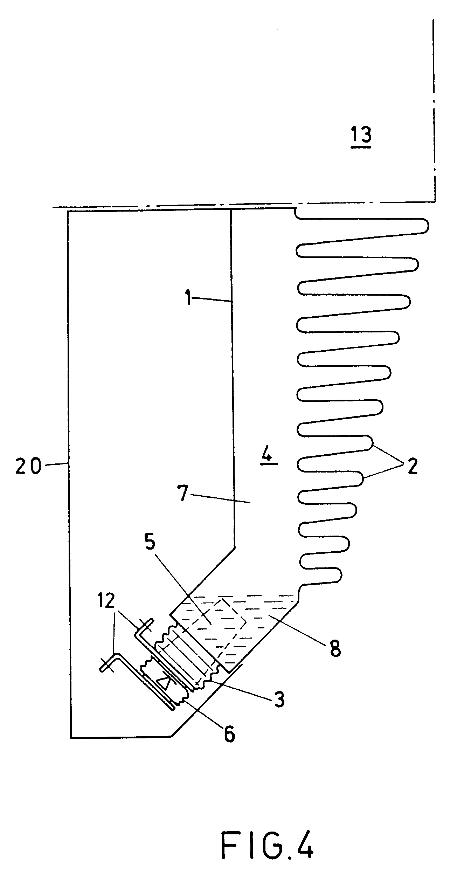

Eine weitere für die Unterflurmontage in Traktionsfahrzeugen vorgesehene, bewährte Ausführungsform der erfindungsgemässen Kühlvorrichtung ist in Fig. 4 dargestellt. Angedeutet ist hier ein Fahrzeug 13, an dessen Unterseite die Kühlvorrichtung befestigt ist. Der Kühlkörper 1, der hier aus Gründen der Beständigkeit aus rostfreiem Stahlblech besteht, ragt mit seinen Kühlrippen 2 in den Fahrtwind.

Um die vorgegebene Bodenfreiheit zu erreichen, sind das Halbleiterbauelement 6 mit seinen elektrischen Anschlüssen 12, das isolierendes Zwischenstück 3 (hier mit verlängertem Kriechweg !) und der Wärmeableiter 5 schräg nach innen liegend eingebaut. Die Elektronik selbst ist durch ein zusätzliches Gehäuse 20 geschützt.

Eine andere, für die Praxis sehr vorteilhafte Ausführungsform der Erfindung, die speziell auf die Kühlung ganzer Halbleitermodule ausgerichtet ist, ist in den Fig. 5A und 5B in perspektivischer Aussenansicht bzw. im Querschnitt wiedergegeben.

Der Kühlkörper 1 hat hier die Form einer länglichen Platte (Fig. 5A), die auf der einen Plattenseite (in Fig. 5A die Rückseite) mit mehreren Kühlrippen 2 versehen ist. Von der anderen Plattenseite her sind in den Kühlkörper 1 mehrere Hohlräume 4a, 4b eingelassen, z.B. ausgefräst, die in ihrer Ausdehnung an die Abmessungen der zu kühlenden Module angepasst sind.

Die zunächst einseitig offenen Hohlräume 4a, 4b werden von einem Leistungshalbleiter-Modul 18 verschlossen, welches auf einem isolierenden Zwischenstück 3 in Form eines Rahmens montiert ist.

Innerhalb des an sich hermetisch verschlossenen Leistungshalbleiter-Moduls 18 (in Fig. 5A ist die Abdeckung weggelassen, in Fig. 5B nur gestrichelt eingezeichnet) sind beispielsweise ein scheibenförmiges Thyristorelement 14 (ein GTO o.ä.), ein ebenfalls scheibenförmiges Hilfselement 15 (eine Diode o.ä.) und ein rechteckiger Widerstand 16 auf einer gemeinsamen Grundplatte, z.B. einem Metall- oder Keramiksubstrat, angebracht. Die Grundplatte ist zugleich der Wärmeableiter 5 (Fig. 5B), der auf der dem Hohlraum 4 zugewandten Seite in Kontakt mit der Kühlflüssigkeit 8 steht.

Handelt es sich bei einzelnen Modulelementen um besonders stark wärmeerzeugende Elemente (wie z.B. beim Thyristorelement 14), können im Bereich dieser Modulelemente auf der dem Hohlraum 4 zugewandten Seite der Grundplatte zusätzliche Nute (17 in Fig. 5B) oder Rippen zur Vergrösserung der Oberfläche vorgesehen werden.

Mit dieser Ausführungsform stehen gerade für kompakte Modul-Geräte entsprechend kompakte und sehr leistungsfähige Kühlvorrichtungen zur Verfügung.

**Patentansprüche**

1. Kühlvorrichtung für elektrische Bauelemente, insbesondere für Halbleiterbauelemente hoher Leistung,
   a) mit einem Kühlkörper (1) mit wenigstens einem Hohlraum (4),
   b) der teilweise mit einer Kühlflüssigkeit (8) gefüllt ist und oberhalb der Kühlflüssigkeit (8) einen Gasraum (7) aufweist,
   c) wobei die Kühlflüssigkeit (8) mit dem zu kühlenden Bauelement (6, 14 - 16, 18) über einen Wärmeableiter (5) in wärmeleitendem Kontakt steht,
   d) welcher Wärmeableiter (5) einerseits an dem zu kühlenden Bauelement anliegt und andererseits vom Kühlkörper (1) elektrisch isoliert ist,
   e) wobei der Wärmeableiter (5) aus einem gut wärmeleitenden Metall besteht und
   f) auf seiner dem Hohlraum (4, 4a, 4b) zugewandten Seite mindestens eine Nut (17) oder mindestens eine Rippe zur Vergrösserung seiner Oberfläche aufweist,
   dadurch gekennzeichnet,
   g) dass der Kühlkörper (1) die Form einer Platte hat,
   h) dass auf einer Seite der Platte mehrere Kühlrippen (2) angeordnet sind,
   i) dass sich von der den Kühlrippen gegenüberliegenden Plattenseite mehrere Hohlräume (4, 4a, 4b) ins Innere des Kühlkörpers (1) erstrecken,

j) die teilweise mit Kühlflüssigkeit (8) gefüllt sind,

k) dass die Hohlräume (4a, 4b) durch Leistungshalbleiter-Module (18) abgeschlossen sind, welche je einen Wärmeableiter (5) mit mindestens einem elektrischen Bauelement (14 - 16) aufweisen, und

l) dass zwischen dem Wärmeableiter (5) und dem Kühlkörper (1) ein isolierendes Zwischenstück (3) angeordnet ist.

## Claims

1. Cooling apparatus for electric components, in particular for high power semiconductor components,

a) with a cooling element (1) with at least one cavity (4),

b) which is partially filled with a cooling liquid (8) and exhibits a gas space (7) above the cooling liquid (8),

c) the cooling liquid (8) being in thermally conductive contact with the component (6, 14 - 16, 18) to be cooled via a heat dissipator (5),

d) which heat dissipator (5) on the one hand bears against the component to be cooled and on the other hand is electrically insulated from the cooling element (1),

e) the heat dissipator (5) consisting of a highly thermally conductive metal and

f) exhibiting on its side facing the cavity (4, 4a, 4b) at least one groove (17) or at least one fin to increase its surface,

characterised

g) in that the cooling element (1) has the shape of a plate,

h) in that a plurality of cooling fins (2) are arranged on one side of the plate,

i) in that a plurality of cavities (4, 4a, 4b) extend into the interior of the cooling element (1) from the plate side lying opposite the cooling fins,

j) which are partially filled with cooling liquid (8),

k) in that the cavities (4a, 4b) are sealed by power semiconductor modules (18) which each have one heat dissipator (5) having at least one electric component (14-16), and

l) in that an insulating intermediate piece (3) is arranged between the heat dissipator (5) and the cooling element (1).

## Revendications

1. Dispositif de refroidissement pour des composants électriques, en particulier pour des composants semi-conducteurs à haute puissance,

(a) avec un corps de refroidissement (1) avec au moins une cavité (4),

(b) qui est partiellement rempli d'un liquide de refroidissement (8) et présente une chambre à gaz (7) au-dessus du liquide de refroidissement (8),

(c) dans lequel le liquide de refroidissement (8) est en contact thermoconducteur avec le composant à refroidir (6, 14 - 16, 18) par l'intermédiaire d'un évacuateur de chaleur (5),

(d) lequel évacuateur de chaleur (5) d'une part touche le composant à refroidir et d'autre part est électriquement isolé du corps de refroidissement (1),

(e) dans lequel l'évacuateur de chaleur (5) est constitué d'un métal bon conducteur de la chaleur et

(f) présente sur son côté situé à l'opposé de la cavité (4, 4a, 4b) au moins une rainure (17) ou au moins une ailette pour augmenter sa surface,

caractérisé

(g) en ce que le corps de refroidissement (1) a la forme d'une plaque,

(h) en ce que plusieurs ailettes de refroidissement (2) sont disposées sur un côté de la plaque,

(i) en ce que plusieurs cavités (4, 4a, 4b) s'étendent à l'intérieur du corps de refroidissement (1) à partir du côté de la plaque situé à l'opposé des ailettes de refroidissement,

(j) cavités qui sont partiellement remplies de liquide de refroidissement (8),

(k) en ce que les cavités (4a, 4b) sont fermées par des modules de semi-conducteurs de puissance (18), qui présentent chacun un évacuateur de chaleur (5) avec au moins un composant électrique (14 - 16), et

(l) en ce qu'entre l'évacuateur de chaleur (5) et le corps de refroidissement (1) est disposée une pièce intermédiaire isolante (3).

FIG.1

FIG.2

FIG.3

FIG.4

FIG.5A

FIG.5B